**Europäisches Patentamt**

**European Patent Office**

**Office européen des brevets**

(19)

(11) Veröffentlichungsnummer: **0 304 541**
**A1**

## EUROPÄISCHE PATENTANMELDUNG

(12)

(21) Anmeldenummer: **88106003.2**

(22) Anmeldetag: **15.04.88**

(51) Int. Cl.4: **H01L 21/82 , H01L 21/76**

(30) Priorität: **18.08.87 EP 87111946**

(43) Veröffentlichungstag der Anmeldung:
**01.03.89 Patentblatt 89/09**

(84) Benannte Vertragsstaaten:
**DE FR GB IT NL**

(71) Anmelder: **Deutsche ITT Industries GmbH**
**Hans-Bunte-Strasse 19 Postfach 840**
**D-7800 Freiburg(DE)**

(72) Erfinder: **Gahle, Hans Jürgen, Dr. Ing.**
**Panoramastrasse 13**
**D-7830 Emmendingen(DE)**

(74) Vertreter: **Morstadt, Volker, Dipl.-Ing.**
**c/o Deutsche ITT Industries GmbH**
**Patent/Lizenzabteilung Postfach 840**
**Hans-Bunte-Strasse 19**
**D-7800 Freiburg/Brsg.(DE)**

(54) **Verfahren zum Herstellen implantierter Wannen und Inseln von integrierten CMOS-Schaltungen.**

(57) Die Erfindung beschreibt ein Verfahren zum Herstellen von implantierten Wannen und Inseln von integrierten CMOS-Schaltungen mit einem sogenannten retrograde profile, d.h. Wannen und Inseln mit gegenüber herkömmlichen geringerer Eindringtiefe, flacherem Profil des Dotierstoffs sowie verminderter lateraler Diffusion.

Fig. 3

Fig. 9

EP 0 304 541 A1

## Verfahren zum Herstellen implantierter Wannen und Inseln von integrierten CMOS-Schaltungen

Die Erfindung betrifft ein Verfahren zum Herstellen implantierter Wannen und Inseln von integrierten CMOS-Schaltungen nach dem Oberbegriff des Anspruchs 1 (nach dessen Definition haben Inseln den Substratleitungstyp und Wannen den dazu entgegengesetzten Leitungstyp ( = Wannenleitungstyp)).

Beim üblichen Standard-CMOS-Verfahren ergibt sich durch die Ausbildung der Wannen ein relativ hoher Platzbedarf. Soll die Packungsdichte erhöht werden, so muß die Eindringtiefe der Wanne verkleinert werden. Dadurch würde sich aber die vertikale Stromverstärkung der parasitären Bipolartransistoren erhöhen und somit die latch-up-Gefahr steigen.

Eine Lösung dieses Problems bietet das in der Zeitschrift "IEEE Trans. Electron. Dev." Okt 81, Seiten 115 bis 119 beschriebene Verfahren mit sogenannten retrograde wells. Das sind Wannen und Inseln mit flachem Profil des Dotierstoffs sowie kleiner lateraler Diffusion, bei denen im Gegensatz zu herkömmlichen Wannen, bei denen die Dotierstoffkonzentration kontinuierlich in die Tiefe abnimmt, die Dotierstoffkonzentration mit zunehmender Tiefe zunächst ansteigt und dann erst fällt. Damit gelingt es, die Dotierstoffkonzentration an der Oberfläche so klein zu machen, wie sie für MOS-Transitoren erforderlich ist, jedoch eine ausreichend hohe Gesamtkonzentration zu erzielen, so daß die Stromverstärkung von parasitären Bipolar-Transistoren hinreichend klein ist.

Im Gegensatz zum herkömmlichen CMOS-Verfahren wird bei der Herstellung von retrograde wells zuerst die Feldoxidation im Randbereich der Wanne, durchgeführt, und erst dann werden die dotierenden Ionen implantiert, woran sich die übliche kurze Temperung zum Eintreiben der Ionen anschließt.

Soll nun das bekannte Verfahren auf die Herstellung von twinwells, also von nebeneinander liegenden Wannen und Inseln deren Wanne z.B. mindestens einen p- und deren Insel z.B. mindestens einen n-Kanal-Transistor enthält, angewendet werden, so ist ein zweiter Fotoprozeß mit inverser Wannenmaske erforderlich. Die Dotierungskonzentration des Randbereichs ist dann abhängig von der Feldoxiddicke, der Abschrägung der Feldoxidkante und der Dotierungskonzentration der Wannenimplantation. Will man unabhängig von diesen Parametern die Dotierungskonzentration des Randbereichs steuern, sind für die Feldimplantation zwei zusätzliche Masken erforderlich. Das führt wiederum durch Justiertoleranzen zu vergrößerten Abständen.

Die in den Ansprüchen gekennzeichnete Erfindung löst die Aufgabe, das in der eingangs genannten Druckschrift beschriebene Verfahren so abzuwandeln, daß bei der Herstellung von twinwells keine zusätzlichen Masken benötigt werden und zugleich die Vorteile des damit erzeugten Produkts möglichst erhalten bleiben, insbesondere soll die damit erreichte Packungsdichte nicht verschlechtert werden und die Vermeidung des latch-up-Effekts weitgehend erhalten bleiben.

Die Erfindung wird nun anhand der Figuren der Zeichnung näher erläutert.

Die Fig. 1 bis 3 zeigen schematisch in Schnittansicht das jeweilige Ergebnis von Verfahrensschritten während der Herstellung eines Ausführungsbeispiels einer CMOS-Schaltung mit n-Wannen und $p^+$-Inseln, und

die Fig. 4 bis 9 zeigen schematisch in Schnittansicht das jeweilige Ergebnis von Verfahrensschritten wärend der Herstellung eines Ausführungsbeispiels einer Weiterbildung einer CMOS-Schaltung mit n-Wannen und $p^+$-Inseln.

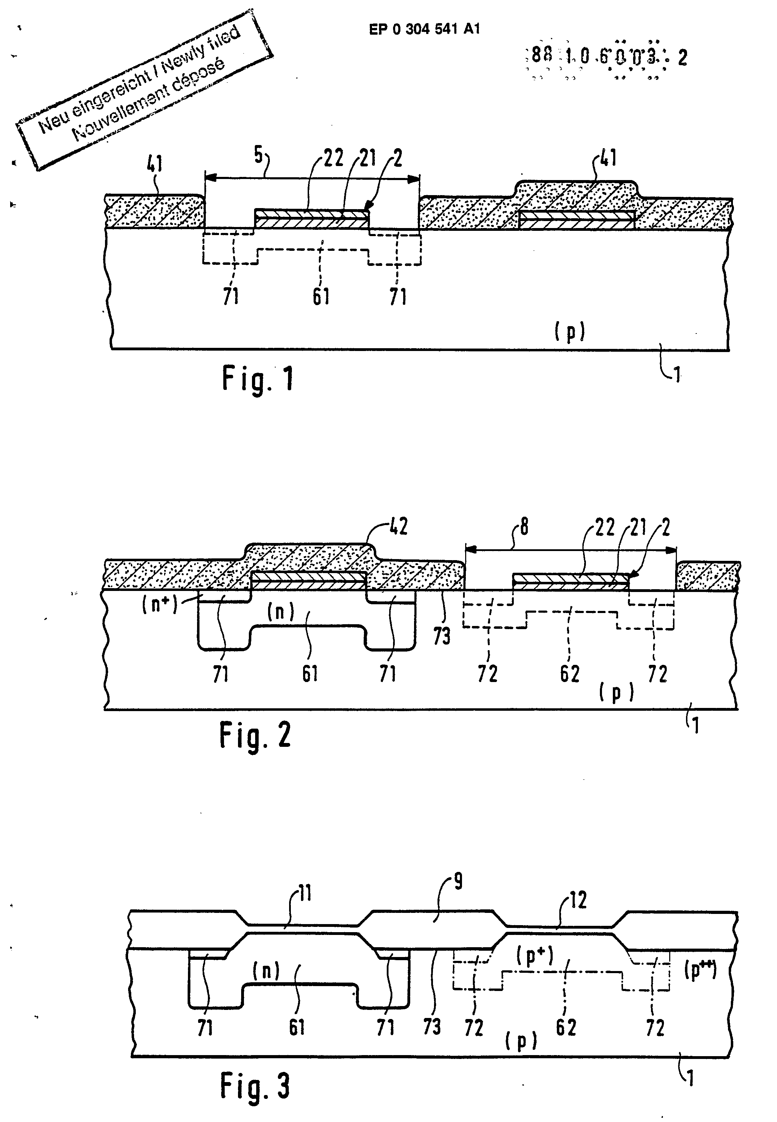

Nach Fig. 1, die wegen des besseren Verständnisses nicht maßstäblich ist, wird bei der Herstellung der CMOS-Schaltung vom p-leitenden Substrat 1 ausgegangen, das mit einer nicht dargestellten Epitaxschicht versehen sein kann. Darauf wird im Verfahrensschritt a) die dünne Siliziumdioxidschicht 21, vorzugsweise durch thermische Oxidation, gebildet. Mit dünn ist die übliche Stärke einer Gateoxidschicht bezeichnet. Auf die Schicht 21 wird die Siliziumnitridschicht 22 aufgebracht. Diese beiden Schichten 21, 22 bilden die Doppelschicht 2.

Die Silizumnitridschicht 22 oder die ganze Doppelschicht 2 wird im Verfahrensschritt b) durch einen üblichen Fotoprozeß - also durch Aufbringen eines Fotolacks, dessen maskierte Belichtung, Abwaschen des unbelichteten (oder des belichteten) Fotolacks und Ätzen der Doppelschicht 2 oder der Schicht 22 mit dem strukturierten Fotolack als Ätzmaske -derart strukturiert, daß die Substratoberfläche (oder nur die Siliziumdioxidschicht 21) im jeweiligen gesamten Randbereich 71 bzw. 72 (siehe Fig. 2) der beabsichtigten Wanne bzw. Insel und im zwischen dem Randbereich der Wanne und dem der Insel liegenden Zwischenbereich 73 freigelegt, dagegen die beiden Schichten 21, 22 im Innenbereich der Wanne bzw. der Insel, also innerhalb des vom jeweiligen Randbereich gebildeten Rings, erhalten bleiben. Der Zwischenbereich 73 ist nicht vorhanden, wenn die Randbereiche 71, 72 sich berühren oder geringfügig überlappen.

Im Verfahrensschritt c) wird die Fotolackschicht 41 aufgebracht und zur Definierung der gesamten Fläche 5 der Wanne 61, die n-leitend werden soll, strukturiert, was als Wannenfotoprozeß bezeichnet wird. Die Fotolackschicht 41 läßt die im Bereich der Wanne 61 liegende Doppelschicht 2 frei, deckt jedoch diejenige im Bereich der späteren Insel 62 ab, die $n^+$-leitend werden soll.

Im Verfahrensschritt d) wird durch einen ersten Implantationsschritt, wobei z.B. Phosphorionen hoher Energie, also Ionen vom Wannenleitungstyp, mit einer Beschleunigungsspannung von etwa 300 kV eingeschossen werden und die Fotolackschicht 41 als Maske dient, die Wanne 61 implantiert (Wannenimplantation).

Im Verfahrensschritt e) wird durch einen zweiten Implantationsschritt mit gegenüber der Wannenimplantation niedriger Energie, wobei z.B. Phosphor- oder Arsenionen mit einer Beschleunigungsspannung von etwa 40 kV eingeschossen werden und wieder die Fotolackschicht 41 sowie die im Bereich der Wanne angeordneten Schichten 21, 22 als Masken dienen, der Randbereich 71 dotiert, der $n^+$-leitend werden soll (Randimplantation I).

Das Ergebnis der bisherigen Verfahrensschritte zeigt Fig. 1.

Im Verfahrensschritt f) wird die Fotolackschicht 41 entfernt, und im Verfahrensschritt g) werden die implantierten Ionen bei entsprechender Temperatur unter Ausbildung der Wanne 61 und deren Randbereichs 71 eingetrieben.

Im Verfahrensschritt h) wird die weitere Fotolackschicht 42 aufgebracht und strukturiert, die die Wanne 61 abdeckt, die Fläche 8 der noch zu erzeugenden Insel 62, die $p^+$-leitend werden soll, dagegen freiläßt, vergleiche Fig. 2, was als Inselfotoprozeß bezeichnet wird.

Nun werden die Verfahrensschritte d) bis g) als Verfahrensschritte d') bis g') wiederholt, wobei jedoch andere Dotiermaterialien unter anderen Bedingungen verwendet werden.

So wird im Verfahrensschritt d') die Insel 62 durch einen dritten Implantationsschritt implantiert, wobei z.B. Borionen hoher Energie, also Ionen vom Substratleitungstyp, mit einer Beschleunigungsspannung von etwa 180 kV eingeschossen werden und die Fotolackschicht 42 als Maske dient, (Inselimplantation).

Im Verfahrensschritt e') wird durch einen vierten Implantationsschritt mit gegenüber der Inselimplantation niedriger Energie, wobei z.B. Bor- bzw. $BF_2$-Ionen mit einer Beschleunigungsspannung von etwa 10 kV bzw. 40 kV eingeschossen werden und wieder die Fotolackschicht 42 sowie die im Bereich der Insel 62 angeordneten Schichten 21, 22 als Masken dienen, der Randbereich 72, der $p^{++}$-leitend werden soll, implantiert (Feldimplantation II).

Das Ergebnis der bisherigen Verfahrensschritte zeigt Fig. 2.

Im Verfahrensschritt f') wird die Fotolackschicht 42 entfernt, und im Verfahrensschritt g') werden die implantierten Ionen bei entsprechender Temperatur unter Ausbildung der $p^+$-leitenden Insel 62 und deren $p^{++}$-leitenden Randbereichs 72 eingetrieben.

Schließlich werden im Verfahrensschritt j) die Randbereiche 71, 72 sowie der Zwischenbereich 73 zur Bildung der Feldoxidschicht 9 thermisch oxidiert und die Doppelschicht 2 dort, wo sie noch vorhanden ist, also über dem jeweiligen Innenbereich der Wanne 61 und der Insel 62, durch Ätzen entfernt.

Bei der anschließenden Weiterverwendung des entsprechend dem Verfahren der Erfindung strukturierten Substrats 1 wird im allgemeinen als erster Schritt auf den erwähnten Innenbereichen die Gateoxidschicht 9 durch deren thermische Oxidation erzeugt werden: das Ergebnis zeigt Fig. 3. Die Fertigstellung der gewünschten CMOS-Schaltungen erfolgt dann im üblicher Weise.

Alternativ zum oben beschriebenen Eintreiben der implantierten Ionen des Substratleitungstyps, z.B. der Borionen, nach Entfernen der Fotolackmaske 42 und der sich daran anschließenden Feldoxidherstellung können diese beiden Verfahrensschritte bevorzugt zusammengefaßt werden; der Verfahrensschritt g') erfolgt somit erst im Verfahrensschritt j).

Bei einer anderen Abwandlung der Erfindung können alternativ zum getrennten Eintreiben der Ionen des Substrat- bzw. Wannenleitungstyps, z.B. der Bor- und Phosphorionen, diese auch in einem gemeinsamen Schritt mit der Feldoxidation eingetrieben werden, wodurch sich annähernd gleiche Eindringtiefe in Wanne und Insel ergibt; die Verfahrensschritte g) und g') erfolgen also erst im Verfahrensschritt j).

Wie die Fig. 1 bis 3 zeigen, ist die durch das geschilderte Verfahren erhaltene Oberfläche des Substrats 1 weitgehend uneben geworden, was für die weiteren Verfahrensschritte störend sein kann.

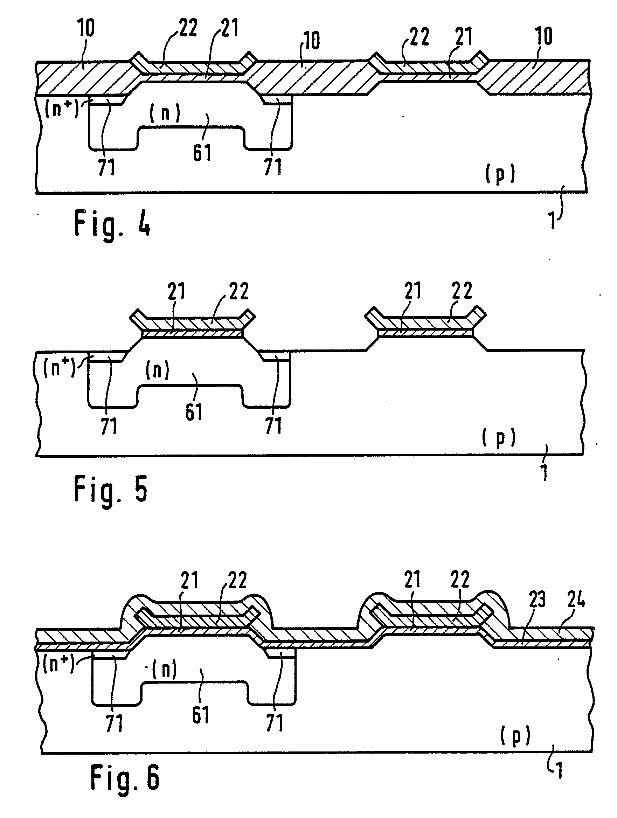

Die anhand der Fig. 4 bis 9 nun zu erläuternde Weiterbildung der Erfindung ergibt ein Wannen und Inseln enthaltendes Substrat mit praktisch ebener Oberfläche. Die Weiterbildung besteht darin, daß nach dem Verfahrensschritt f) und vor dem Verfahrensschritt h) die Verfahrensschritte k) bis n) durchlaufen werden.

Der Verfahrensschritt k) besteht darin, daß der von den beiden Schichten 21, 22 bedeckte Teil der Substratoberfläche während des Verfahrensschritt g) zur Bildung der Dickoxidschicht 10 thermisch oxidiert wird. Diese ist somit der Feldoxidschicht 9 vergleichbar und hat auch etwa deren halbe Dicke. Im Verfahrensschritt k) erfolgt also deren Bildung zusammen mit dem Eintreiben der Wannendotierung; das Ergebnis zeigt Fig. 4.

Im Verfahrensschritt l) wird die Dickoxidschicht 10 unmaskiert vollständig weggeätzt; das Ergebnis zeigt Fig. 5.

Im Verfahrensschritt m) werden die freiliegenden Teile der nunmehrigen Substratoberfläche zur Bildung der dünnen Siliziumdioxidschicht 23 thermisch oxidiert, und darauf wird die weitere Siliziumnitridschicht 24 aufgebracht; das Ergebnis zeigt Fig. 6.

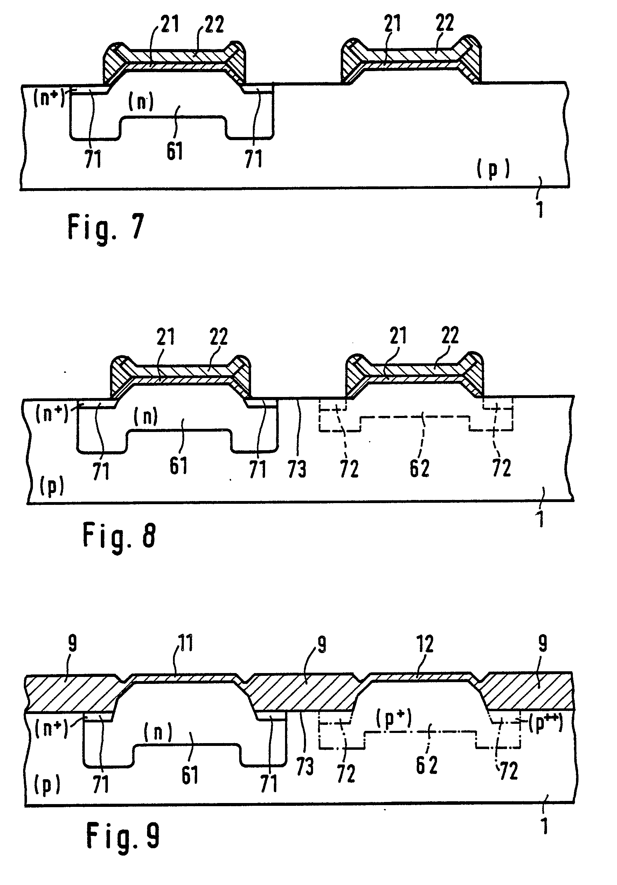

Im Verfahrensschritt n) wird die Siliziumnitridschicht 24 anisotrop, also senkrecht zur Substratoberfläche, geätzt. Dadurch ergibt sich die in Fig. 7 gezeigte Ausbildung, bei der seitlich unter der von der Bildung der Dickoxidschicht 10 her bewirkten Aufbiegung der Nitridschicht 22 ein Rest der Nitridschicht 24 erhalten geblieben ist, der praktisch senkrecht zum Substrat verlaufende Wände hat.

Nun schließen sich die Verfahrensschritte h), i)- (= d′), e′), f′), g′)) und j) an. Fig. 8 zeigt das Ergebnis nach Verfahrensschritt f′), Fig. 9 das nach Verfahrensschritt j) und nach der oben erwähnten analogen Erzeugung der Gateoxidschichten 11, 12.

Das Verfahren der Erfindung eignet sich nicht nur zur Erzeugung der Wannen und Inseln von reinen CMOS-Schaltungen, sondern es läßt sich auch bei der Herstellung der Wannen und Inseln von kombinierten Bipolar-CMOS-Schaltungen anwenden.

Die Weiterbildung nach den Fig. 4 bis 9 kann auch bei reinen N-Kanal-Schaltungen entsprechend angewendet werden.

**Ansprüche**

1. Verfahren zum Herstellen implantierter Wannen und Inseln von integrierten CMOS-Schaltungen (= komplementäre Isolierschicht-Feldeffekttransistor-Schaltungen) aus Silizium, bei dem durch mehrfache Ionenimplantation unter Verwendung von Fotolack- und Siliziumdioxid/-nitrid-Maskierungsstrukturen in einem Substrat (1) des einen Leitungstyps (= Substratleitungstyp) mindestens eine Wanne (61) des entgegengesetzten Leitungstyps (= Wannenleitungstyp) und in deren Nachbarschaft mindestens eine höher als das Substrat (1) dotierte Insel (62) des Substratleitungstyps erzeugt werden, gekennzeichnet durch die Aufeinanderfolge der Verfahrensschritte:

a) Bildung einer dünnen Siliziumdioxidschicht (21) auf dem Substrat (1) und einer Siliziumnitridschicht (22) darauf der Siliziumdioxidschicht (21),

b) Fotoprozeß zur derartigen Strukturierung von mindestens der Siliziumnitridschicht (22), daß nur die Siliziumdioxidschicht (21) bzw. die Substratoberfläche in einem jeweiligen gesamten Randbereich (71, 72) der beabsichtigten Wanne bzw. Insel und in einem gegebenenfalls zwischen dem Randbereich der Wanne und dem der Insel liegenden Zwischenbereich (73) freigelegt, dagegen die beiden Schichten (21, 22) im Innenbereich der Wanne bzw. der Insel erhalten bleiben,

c) Aufbringen einer Fotolackschicht (41) und deren Strukturierung zur Definierung der gesamten Fläche (5) der Wanne (61) (= Wannenfotoprozeß),

d) Implantation von Ionen hoher Energie und des Wannenleitungstyps unter Verwendung der strukturierten Fotolackschicht (41) als Maske,

e) Implantation von Ionen niedriger Energie und des Wannenleitungstyps unter Verwendung der strukturierten Fotolackschicht (41) und der beiden Schichten (21, 22) als Maske,

f) Entfernen der strukturierten Fotolackschicht (41),

g) Eintreiben der implantierten Ionen unter Ausbildung der Wanne (61) und deren höher als sie dotierten Randbereichs (71),

h) Aufbringen einer weiteren Fotolackschicht (42) und deren Strukturierung zur Festlegung der gesamten Fläche (8) der Insel (62) (= Inselfotoprozeß),

i) Wiederholung der Verfahrensschritte d) bis g) als Schritte d′) bis g′) unter Verwendung von Ionen des Substratleitungstyps zur Bildung der Insel (62) und deren höher als sie dotierten Randbereichs (72), und

j) Oxidation der freigelegten Randbereiche (71, 72) und gegebenenfalls des Zwischenbereichs (73) zur Bildung einer Feldoxidschicht (9) und anschließende Entfernung der Doppelschicht (2).

2. Verfahren nach Anspruch 1, gekennzeichnet durch die Einfügung der Aufeinanderfolge folgender weiterer Verfahrensschritte nach Verfahrensschritt f) und vor Verfahrensschritt h):

k) Oxidation der von den beiden Schichten (21, 22) nicht bedeckten Teile der Siliziumdioxidschicht (21) bzw. der Substratoberfläche im Verfahrensschritt g′ zur Erzeugung einer Dickoxidschicht (10),

l) unmaskiertes Wegätzen der Dickoxidschicht (10),

m) Oxidation der freiliegenden Teile der Substratoberfläche zur Bildung einer weiteren dünnen Siliziumdioxidschicht (23) und Bildung einer weiteren Siliziumnitridschicht (24) darauf und

n) anisotropes Wegätzen der weiteren Siliziumnitridschicht (24).

3. Verfahren nach Anspruch 1, dadurch gekennzeichnet, daß das Eintreiben der Ionen es Substratleitungstyps (= Verfahrensschritt g′)) erst im Verfahrensschritt j) erfolgt.

4. Verfahren nach Anspruch 1, dadurch gekennzeichnet, daß das jeweilige Eintreiben der Ionen zur Bildung der Wanne (61) (= Verfahrensschritt g)) und der Insel (62) (= Verfahrensschritt g′)) erst im Verfahrensschritt j) gemeinsam erfolgt.

5. Verfahren nach einem der Ansprüche 1 bis 4, dadurch gekennzeichnet, daß eine p-leitende Wanne bzw. eine $p^+$-leitende Insel (62) durch Implantation von Bor-Ionen hoher Energie und der zugehörige Randbereich (71) durch Implantation von Bor- oder $BF_2^+$-Ionen niedriger Energie erzeugt wird.

6. Verfahren nach einem der Ansprüche 1 bis 4, dadurch gekennzeichnet, daß eine n-leitende Wanne (61) bzw. $n^+$-leitende Insel durch Implantation von vorzugsweise doppelt positiv geladenen Phosphorionen hoher Energie und der zugehörige Randbereich (72) durch Implantation von Phosphor- oder Arsenionen niedriger Energie erzeugt wird.

88 10.6003 2

**Fig. 1**

41  5  22  21  2  41

71  61  71

( p )

1

**Fig. 2**

42  8  22  21  2

( n⁺ )  73

71  61  71  72  62  72

( p )  1

**Fig. 3**

11  9  12

( n )  ( p⁺ )  ( p⁺⁺ )

71  61  71  73  72  62  72

( p )  1

88 10 60 03 . 2

Fig. 4

Fig. 5

Fig. 6

88 10 60 03 . 2

Fig. 7

Fig. 8

Fig. 9

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EXTENDED ABSTRACTS, Band 87-1, Nr. 1, Sommer 1987, Seiten 213-214, Zusammenfassung Nr. 154, Philadelphia, PA, US; D. SHARMA et al.: "A 1mum CMOS technology with low temperature processing" * Insgesamt * --- | 1,3-6 | H 01 L 21/82 H 01 L 21/76 |
| A | EP-A-0 144 248 (FUJITSU) * Figuren 6A-6G; Seite 11, Zeile 12 - Seite 15, Zeile 9 * --- | 1,3-6 | |
| A | IEEE ELECTRON DEVICE LETTERS, Band EDL-7, Nr. 2, February 1986, Seiten 124-126, IEEE, New York, US; H.-H. TSAI et al.: "A new fully recessed-oxide (FUROX) field isolation technology for scaled VLSI circuit fabrication" * Figur 1 * --- | 2 | |
| A | JOURNAL OF THE ELECTROCHEMICAL SOCIETY, Band 134, Nr. 6, June 1987, Seiten 1503-1507, Manchester, NH, US; K. SAKUMA et al.: "A new self-aligned planar oxidation technology" * Insgesamt; insbesondere Figur 1 * --- | 2 | RECHERCHIERTE SACHGEBIETE (Int. Cl.4) H 01 L |
| A,P | IEEE TRANSACTIONS ON ELECTRON DEVICES, Band 35, Nr. 3, März 1988, Seiten 275-284, IEEE, New York, US; H.-H. TSAI et al.: "An evaluation of FUROX isolation technology for VLSI/nMOSFET fabrication" * Figuren 1,4 * ------ | 2 | |

Der vorliegende Recherchenbericht wurde für alle Patentansprüche erstellt

| Recherchenort | Abschlußdatum der Recherche | Prüfer |
|---|---|---|
| DEN HAAG | 24-11-1988 | MACHEK,J. |